(19) Europäisches Patentamt / European Patent Office / Office européen des brevets

(11) **EP 3 127 160 B1**

(12) **FASCICULE DE BREVET EUROPEEN**

(45) Date de publication et mention de la délivrance du brevet:
**20.02.2019 Bulletin 2019/08**

(21) Numéro de dépôt: **15713536.9**

(22) Date de dépôt: **03.04.2015**

(51) Int Cl.:
*H01L 29/32* (2006.01)       *H01L 29/36* (2006.01)
*H01L 29/778* (2006.01)       *H01L 29/20* (2006.01)
*H01L 29/205* (2006.01)

(86) Numéro de dépôt international:
**PCT/EP2015/097004**

(87) Numéro de publication internationale:
**WO 2015/150582 (08.10.2015 Gazette 2015/40)**

(54) **COUCHE TAMPON OPTIMISÉE POUR TRANSISTOR A EFFET DE CHAMP A HAUTE MOBILITÉ**

OPTIMIERTE PUFFERSCHICHT FÜR FELDEFFEKTTRANSISTOR MIT HOHER MOBILITÄT

OPTIMIZED BUFFER LAYER FOR HIGH MOBILITY FIELD-EFFECT TRANSISTOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.04.2014 FR 1400825**

(43) Date de publication de la demande:
**08.02.2017 Bulletin 2017/06**

(73) Titulaires:
• **THALES**
  **92400 Courbevoie (FR)**
• **Commissariat à l'Énergie Atomique et aux Énergies Alternatives**
  **75015 Paris (FR)**

(72) Inventeurs:
• **JACQUET, Jean-Claude**
  **91400 Orsay (FR)**
• **AUBRY, Raphaël**
  **91940 Gometz Le Chatel (FR)**
• **GAMARRA, Piero**
  **91120 Palaiseau (FR)**
• **JARDEL, Olivier**
  **31500 Toulouse (FR)**
• **PIOTROWICZ, Stéphane**
  **78114 Magny les Hameaux (FR)**

(74) Mandataire: **Joubert, Cécile**
**Marks & Clerk France**
**Counseils en Propriete Industrielle**
**Immeuble "Visium"**
**22, avenue Aristide Briand**
**94117 Arcueil Cedex (FR)**

(56) Documents cités:
**US-A1- 2010 289 067       US-A1- 2012 025 268**
**US-A1- 2013 200 389       US-A1- 2013 328 106**

**Description**

DOMAINE DE L'INVENTION

La présente invention concerne les transistors à effet de champ à haute mobilité électronique dénommés transistors HEMT (acronyme de l'expression anglo-saxonne « High Electron Mobility Transistor »).

La présente invention concerne plus particulièrement les empilements à partir desquels sont fabriqués les transistors HEMT utilisés comme amplificateur faible bruit ou de puissance, comme commutateur ou comme oscillateur et couvrant la gamme de fréquence comprise typiquement entre 1MHz et 100GHz.

ETAT DE LA TECHNIQUE

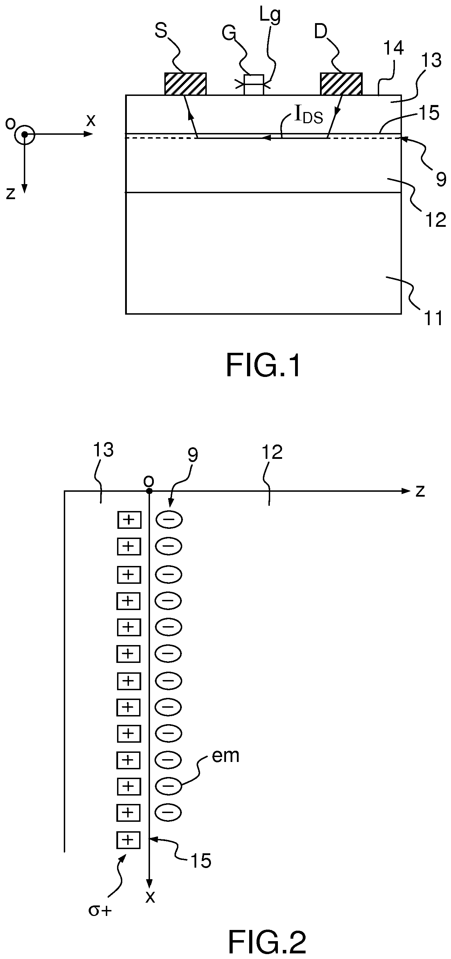

La figure 1 représente schématiquement une coupe de la structure d'un système de transistor HEMT élémentaire classique, dans un plan Oxz, réalisé sur un substrat 11. Classiquement on utilise un substrat 11 isolant ou semi-conducteur, par exemple comprenant du silicium (Si), du Carbure de Silicium (SiC) ou du Saphire ($Al_2O_3$), sur lequel est réalisé un empilement selon l'axe z d'au moins deux couches de semi-conducteur qui s'étendent dans le plan Oxy.

Une première couche 12, dénommée couche tampon, ou « buffer » (terme utilisé dans la littérature anglo-saxonne), présente une large bande interdite (matériau semi-conducteur dit à grand gap) par exemple comprenant un matériau composé binaire de l'azote, tel le GaN ou un matériau à base de composé ternaire de nitrure d'éléments III, dénommé III-N, tel que l'AlGaN, ou plus précisément l'$Al_xGa_{1-x}N$.

Une seconde couche, dénommée couche barrière 13, présente une bande interdite plus grande que celle de la couche tampon 12. Cette couche comprend un matériau à base de composé quaternaire, ternaire ou binaire de nitrure d'éléments III, dénommé III-N, à base de Al, Ga, In ou B.

Par exemple, avec une couche tampon en GaN, la couche barrière comprend de l'$Al_xGa_{1-x}N$ ou de l'$In_{1-x}Al_xN$, ou une séquence $In_{1-x}Al_xN/AlN$ ou $Al_xGa_{1-x}/AlN$.

Selon la teneur x en aluminium, les largeurs de bandes interdites de l'$Al_xGa_{1-x}N$ et de l'$In_{1-x}Al_xN$ varient de 3.4eV (GaN) à 6.2eV (AlN) et de 0.7eV (InN) à 6.2eV (AlN) respectivement.

L'épaisseur de la couche barrière 13 est typiquement comprise entre 5 nm et 40 nm, l'épaisseur de la couche tampon 12 est typiquement comprise entre 0.2 $\mu$m et 3 $\mu$m.

Des couches supplémentaires peuvent être présentes soit en surface, soit entre la couche tampon et la couche barrière.

La couche tampon 12 et la couche barrière 13 sont classiquement réalisées par épitaxie par MOCVD ou par MBE. A titre d'exemple, on peut citer une couche tampon à base de GaN avec une couche barrière à base d'AlGaN ou d'InAlN, et plus précisément à base d'$Al_xGa_{1-x}N$ ou d'$In_zAl_{1-z}N$, avec x compris typiquement entre 15% et 35% et z compris typiquement entre 15% et 25%.

La jonction entre la couche tampon et la couche barrière constitue une hétérojonction 15 qui s'étend également dans le plan Oxy. L'origine O du repère Oxyz est choisie dans ce plan.

Un transistor HEMT comprend classiquement une source S, un drain D et une grille G déposés sur la face supérieure 14 de la couche barrière 13.

La grille G est déposée entre la source S et le drain D et permet de commander le transistor. La conductance entre la source S et le drain D est modulée par l'action électrostatique de la grille G, classiquement de type Schottky ou de type MIS pour (métal/isolant/semiconducteur), et la tension $V_{GS}$ appliquée entre la grille et la source commande le transistor.

Un gaz bidimensionnel d'électrons 9 (dénommé 2DEG pour « two-Dimensional Electron Gas ») est localisé au voisinage de l'hétérojonction 15. Ces électrons sont mobiles dans le plan Oxy et ont une forte mobilité électronique $\mu$e, typiquement supérieure à 1000$cm^2$/Vs. Dans un fonctionnement normal du transistor ces électrons ne peuvent pas circuler dans la direction z car ils sont confinés dans le puits de potentiel se formant dans le plan Oxy au voisinage de l'hétérojonction 15. Le gaz d'électrons 9, confiné dans ce qui est dénommé le canal du transistor, est donc apte à transporter un courant $I_{DS}$ circulant entre le drain et la source. Classiquement, une différence de potentiel $V_{DS}$ est appliquée entre la source S et le drain D, avec typiquement une source S à la masse, et la valeur du courant $I_{DS}$ est une fonction de la tension appliquée $V_{GS}$ entre la grille G et la source S.

L'effet transistor est basé sur la modulation de la conductance gm entre les contacts S et D par l'action électrostatique de l'électrode de commande G. La variation de cette conductance est proportionnelle au nombre de porteurs libres dans le canal, et donc au courant entre source et drain. C'est l'effet d'amplification transistor qui permet de transformer un faible signal appliqué sur la grille en un signal plus fort récupéré sur le drain.

La figure 2 représente la répartition des charges au voisinage de l'hétérojonction. Les matériaux de la famille des III-N sont fortement électronégatifs. Lorsque l'on met en contact deux composés différents de cette famille une charge électrique fixe pouvant être positive ($\sigma$+) (figure 2) ou négative ($\sigma$-) apparait à leur interface. Cette charge fixe attire des charges mobiles (électrons lorsqu'elle est positive telle que dans la figure 2 ou trous lorsqu'elle est négative). Ce sont ces charges mobiles em qui créent un courant lorsqu'une tension est appliquée entre le drain et la source.

Le GaN est un semi-conducteur qui, dans les conditions de croissance habituelles, est dopé en impuretés de type donneur (N) (typiquement des lacunes d'azote). Ce type de défauts ne permet pas d'obtenir un confinement des électrons dans le canal lorsque la tension appliquée sur le drain du transistor devient trop grande (typiquement supérieure à 10 V et lorsque la longueur de la grille Lg devient trop courte (typiquement inférieure à 0.25 $\mu$m). Les électrons circulent alors dans la couche tampon ce qui a pour conséquence une diminution de la conductance gm du transistor.

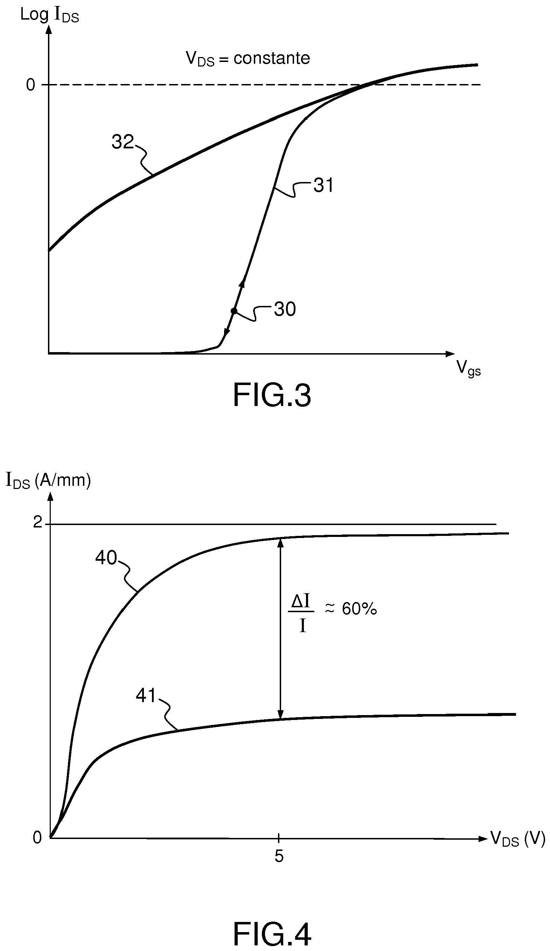

Ce mauvais confinement des électrons dans le canal se traduit sur la caractéristique de transfert Log($I_{DS}$) = f($V_{GS}$) par une diminution de la pente gm = $\Delta I_{DS}/\Delta V_{GS}$ telle qu'illustrée figure 3. Cette diminution indique une moins grande efficacité à moduler le courant par la grille.

Un bon fonctionnement du transistor est obtenu lorsque la courbe 31 Log($I_{DS}$)= f($V_{GS}$), à $V_{DS}$ constant élevé (par exemple 20V) et pour une grille courte (par exemple inférieure à 0.25$\mu$m), présente une pente raide, telle qu'illustrée figure 3. Cette pente raide caractérisée par une transconductance $g_m$ élevée traduit la capacité du transistor à moduler de forts courants avec un gain en puissance suffisant au point de fonctionnement 30. On dit dans ce cas que le « pincement » du transistor est bon. La courbe 32 illustre un transistor présentant un mauvais « pincement ». Il est possible de quantifier cette valeur par une grandeur appelée 'Subthreshold Slope' dans la littérature anglo-saxonne ou pente avant le seuil de pincement en français. Une valeur de celle-ci inférieure à 150mV/décade de courant est recherchée.

Pour obtenir un fonctionnement du transistor avec une pente avant le seuil de pincement inférieure à 150mV/décade pour les tensions de fonctionnement souhaitées il est nécessaire de compenser le dopage N initial.

Une première solution est de doper P le « buffer » (GaN ou $Al_xGa_{1-x}N$) en introduisant des impuretés de type accepteur, par exemple par modification des conditions d'épitaxie ou par l'ajout lors de la croissance d'impuretés de type accepteur. La densité d'impuretés introduite dans le « buffer » est optimisée pour obtenir le comportement transistor souhaité.

Les impuretés compatibles sont principalement le Carbone et le Fer mais peuvent aussi être du Magnésium du Béryllium ou du Zinc ou toutes impuretés connues pour être un centre accepteur dans le GaN. Typiquement un excès en impuretés de type P par rapport aux impuretés de type N de quelques $10^{16}$ cm$^{-3}$ à quelques $10^{17}$ cm$^{-3}$ permet d'obtenir une pente avant le seuil de pincement inférieure à 150mV/décade pour des tensions de fonctionnement maximale de 50V ($V_{DS}$) et des grilles de 0.15$\mu$m de long.

Ces impuretés constituent cependant des centres profonds. On appelle centre profond une impureté dont le niveau d'énergie est situé à plus de 2 à 3 fois l'énergie d'activation thermique (= 3/2 $k_b$*T) du minimum de la bande de conduction pour une impureté de type N ou du maximum de la bande de valence pour une impureté de type P. A température ambiante l'énergie d'activation thermique est de l'ordre de 40meV. Un centre sera donc considéré comme profond lorsqu'il sera situé à plus de 100meV de l'un de ces extrema, ce qui est le cas pour le GaN dopé en impureté de type accepteur.

Ces centres se chargent négativement lorsque le transistor est mis sous tension et comme ils sont profonds ne se déchargent pas aux fréquences de fonctionnement supérieures au MHz. Cela a pour effet de réduire la charge mobile présente dans le canal conducteur, ce qui réduit le courant et augmente la résistance d'accès. Il s'ensuit que cette approche a pour principal inconvénient en sus de générer de la dispersion, de réduire le rendement du transistor et la puissance qu'il peut émettre. Cette dégradation des performances est d'autant plus prononcée que la tension $V_{DS}$ de fonctionnement du transistor est élevée (typiquement supérieure à 20V).

Cette diminution de la charge mobile, dénommée «current collapse» en terminologie anglo-saxonne est illustrée figure 4. Dans cet exemple le buffer du transistor en GaN est dopé P uniformément à une valeur de 5. $10^{17}$ atomes / cm$^3$.

La courbe 40 illustre une caractéristique courant/tension d'un transistor (réalisée à $V_{GS}$ = 0V) qui n'a pas été mis sous tension préalablement à l'établissement de la caractéristique.

La courbe 41 illustre une caractéristique courant/tension du transistor (réalisée à $V_{GS}$ = 0V) qui a subi une contrainte sous la forme d'une tension = $V_{GS}$ = -6V et $V_{DS}$ = 40V, préalablement à l'établissement de la caractéristique.

On constate que sur la courbe 41 $I_{DS}$ en fonction de $V_{DS}$ est modifiée par rapport à la courbe 40 initiale. La caractéristique courant/tension est dégradée, avec sur cet exemple une variation relative de 60 % du courant $I_{DS}$ (et donc de la puissance disponible) à une tension $V_{DS}$ de 5V.

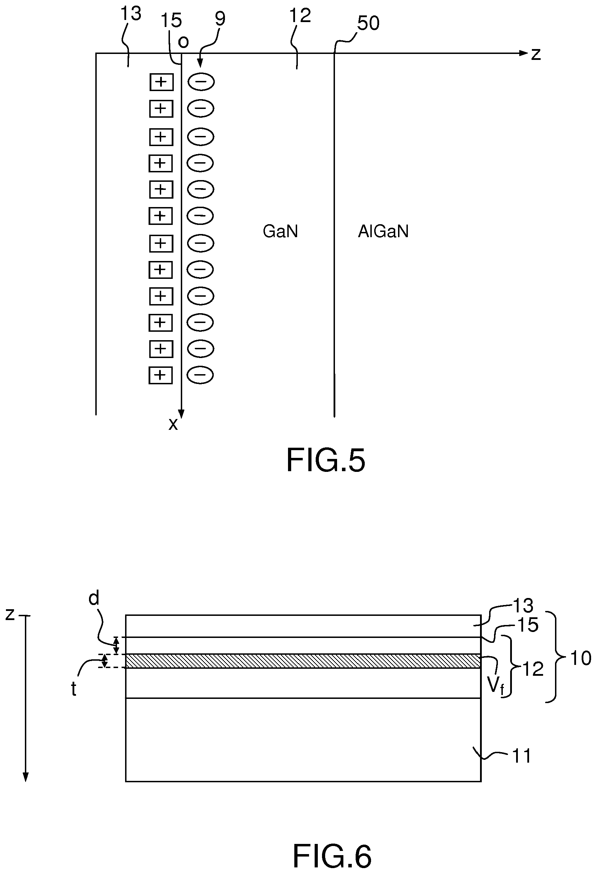

Une deuxième solution est de réaliser un buffer composite GaN / $Al_xGa_{1-x}N$ par exemple, tel qu'illustré figure 5, avec le canal en GaN. Dans ce cas la charge piézoélectrique négative apparaissant à l'interface 50 GaN / $Al_xGa_{1-x}N$ créée une barrière de potentiel permettant de confiner les électrons dans le canal. Quelques pourcent d'aluminium dans la couche d'$Al_xGa_{1-x}N$ (typiquement 3% à 10%) sont nécessaires pour obtenir un bon confinement des électrons pour une tension de fonctionnement maximale comprise entre 20V et 40V et une longueur de grille inférieure à 0.25$\mu$m.

Cependant la conductivité thermique de l'$Al_xGa_{1-x}N$ est inférieure à celle du GaN d'un facteur compris entre 3 et 5 pour les taux d'aluminium nécessaire à un bon confinement des électrons. La résistance thermique du transistor est ainsi fortement dégradée, multipliée par 2 à 3, et la puissance pouvant être émise réduite d'un facteur 1,5 à 3 (selon les applications visées) avec cette solution.

Le document US2013/0328106 décrit un transistor à effet de champ à haute mobilité électronique.

Un but de l'invention est de pallier aux inconvénients précités en proposant un empilement optimisé pour transistor HEMT, permettant au transistor HEMT réalisé à partir de cet empilement de présenter de bonnes caractéristiques courant/tension, traduisant un bon confinement des électrons dans le canal et une faible dispersion de courant, y compris lorsque le transistor doit fonctionner à haute fréquence (faibles dimensions de grille) ou à des tensions de drain $V_{DS}$ élevées.

DESCRIPTION DE L'INVENTION

Plus précisément l'invention a pour objet un empilement selon un axe z pour transistor à effet de champ à haute mobilité électronique selon la revendication 1.

Préférentiellement les impuretés de type accepteur sont du Carbone ou du Fer ou du Magnésium.

Préférentiellement la densité volumique de charges négatives fixes à l'équilibre thermodynamique est sensiblement égale à la densité volumique d'impuretés de type accepteur introduites dans ladite zone de la couche tampon.

Préférentiellement, la densité volumique de charges négatives fixes est supérieure ou égale à $10^{18}$ cm$^{-3}$, l'épaisseur de la zone est inférieure ou égale à 40 nm, le produit de la densité volumique de charges négatives fixes par l'épaisseur de la zone est inférieur ou égal à $4.10^{12}$ cm$^{-2}$, et ces charges sont situées à une distance de l'hétérojonction inférieure ou égale à 40 nm. Préférentiellement, le premier matériau semi conducteur comprend du GaN. Préférentiellement, le deuxième matériau semi conducteur comprend de l'AlN, de l'AlGaN, de l'InAlN, de l'InGaAlN ou du BGaAlN.

Selon une variante, la densité volumique de charges négatives fixes présente un profil selon l'axe z en forme de créneau.

Selon une autre variante, la densité volumique de charges négatives présente un profil selon l'axe z trapézoïdal présentant une première pente croissante puis une valeur constante puis une deuxième pente décroissante. Selon une autre variante la densité volumique de charges négatives fixes présente un profil selon l'axe z en forme de cloche.

Selon un mode de réalisation, la couche tampon est composite, et comprend une première couche tampon à base de matériau GaN et une deuxième couche tampon à base de matériau AlGaN, la zone Vf étant comprise dans la première couche tampon.

Selon un autre aspect, l'invention a pour objet un transistor à effet de champ à haute mobilité électronique réalisé à partir d'un empilement selon l'invention.

Selon un mode de réalisation, le transistor présente une longueur de grille Lg et la distance à l'hétérojonction de la zone est inférieure ou égale à la longueur de grille Lg.

Préférentiellement, le produit de la densité volumique de charges négatives fixes par l'épaisseur de la zone vérifie la relation suivante :

$$[Fv].\, t = (1\pm0.3) \times 10^{13} \times V_{DSMAX}\, /\, Lg$$

dans laquelle :

Lg est la longueur de grille du transistor, en nm
$V_{DSMAX}$ est la tension maximale appliquée entre la source et le drain du transistor, en Volt,
$[Fv].\, t$ est exprimé en cm$^{-2}$.

D'autres caractéristiques, buts et avantages de la présente invention apparaîtront à la lecture de la description détaillée qui va suivre et en regard des dessins annexés donnés à titre d'exemples non limitatifs et sur lesquels :

- la figure 1 déjà citée représente schématiquement une coupe de la structure d'un transistor HEMT classique,
- la figure 2 déjà citée représente la répartition des charges au voisinage de l'hétérojonction du transistor HEMT classique,
- la figure 3 déjà citée représente schématiquement la caractéristique courant/tension d'un transistor HEMT présentant un bon et un mauvais « pincement »,
- la figure 4 déjà citée illustre schématiquement le comportement d'un transistor HEMT selon l'état de la technique présentant une dispersion en courant,
- la figure 5 déjà citée illustre schématiquement un empilement d'un transistor selon un état de la technique présentant une couche tampon composite,
- la figure 6 illustre un empilement pour transistor à effet de champ selon l'invention,
- la figure 7 décrit plus précisément la structure des charges dans l'empilement selon l'invention,

- la figure 8 illustre différentes formes de profil de densité volumique de charges négatives fixes selon l'invention,
- la figure 9 schématise la différence entre le profil d'impuretés introduites et le profil d'impuretés chargées pour trois valeurs de distance d entre la zone Vf et l'hétérojonction,
- la figure 10 illustre la caractéristique Log[$I_{DS}$] = f(Vgs) pour un transistor HEMT réalisé avec l'empilement selon l'invention, pour trois valeurs de distance d entre la zone Vf et l'hétérojonction,
- la figure 11 illustre la dispersion en courant pour trois valeurs de distance d entre la zone Vf et l'hétérojonction,
- la figure 12 schématise la différence entre le profil d'impuretés introduites et le profil d'impuretés chargées pour trois valeurs d'épaisseur t de la zone Vf,
- la figure 13 illustre une variante de l'empilement selon l'invention présentant une couche tampon composite.

## DESCRIPTION DETAILLEE DE L'INVENTION

La figure 6 illustre un empilement 10 pour transistor à effet de champ à haute mobilité électronique (HEMT) selon l'invention.

L'empilement 10 selon l'invention est réalisé à partir d'un substrat 11 classique pour ce type de composant.

L'empilement 10 comprend une pluralité de couches selon un plan xy perpendiculaire à un axe z. Par convention l'empilement est dit « selon l'axe z ».

L'empilement 10 comprend une couche tampon 12 comprenant un premier matériau semi-conducteur comprenant un composé binaire ou ternaire de nitrure et présentant une première bande interdite. Le premier matériau semi conducteur est dit « grand gap » selon la terminologie classique.

Préférentiellement le premier matériau semi conducteur comprend du GaN. En variante il comprend de l'AlGaN, plus précisément de l'$Al_xGa_{1-x}N$, avec x compris typiquement entre 1% et 35%. La couche tampon est déposée sur le substrat 11. L'épaisseur de cette couche est suffisante pour garantir une bonne qualité cristalline du matériau à l'interface avec la couche barrière ou se forme le canal conducteur.

L'empilement comprend également une couche barrière 13 comprenant un deuxième matériau semi-conducteur comprenant un composé binaire, ou ternaire, ou quaternaire de nitrure et présentant une deuxième bande interdite.

Selon une variante, la couche barrière comprend de l'AlN.

Selon une deuxième variante, préférentiellement, la couche barrière comprend de l'AlGaN ou de l'InAlN, et plus précisément de l'$Al_xGa_{1-x}N$ ou de l'$In_yAl_{1-y}N$ avec x compris typiquement entre 15% et 35% et y compris typiquement entre 15% et 25%.

Selon une troisième variante, la couche barrière comprend du BAlGaN ou de l'InGaAlN.

La deuxième bande interdite est supérieure à la première bande interdite, selon la structure classique d'un empilement pour transistor HEMT.

L'empilement présente une hétérojonction 15 entre la couche tampon 12 et la couche barrière 13 et un gaz bidimensionnel d'électrons 9 localisé dans un plan xy perpendiculaire à l'axe z et au voisinage de l'hétérojonction 15, selon la structure classique d'un empilement pour transistor HEMT. Préférentiellement les matériaux des couches tampon 12 et barrière 13 sont des semi conducteurs classiquement utilisés pour la fabrication de transistor HEMT à base de gallium (Ga).

Des couches intermédiaires peuvent être insérées entre la couche tampon et le substrat, ou entre la couche tampon et la couche barrière, mais ne sont pas décrites ici par souci de simplification.

La couche tampon 12 de l'empilement selon l'invention présente une structure particulière optimisée pour l'amélioration des performances des transistors HEMT réalisés à partir de l'empilement 10 selon l'invention, par dépôt de structures de grilles, de sources et de drains selon l'état de la technique des transistors HEMT.

La couche tampon 12 de l'empilement selon l'invention comprend une zone Vf comprenant des charges négatives fixes localisées à un endroit spécifique de la couche tampon. On entend par charges négatives fixes des charges non mobiles (charges mobiles dans ce contexte signifie électrons ou trous), le terme mobile étant entendu au sens habituel dans le domaine de la physique des semi-conducteurs. La zone Vf s'étend selon le plan xy, est située à une distance d de l'hétérojonction et présente une épaisseur t.

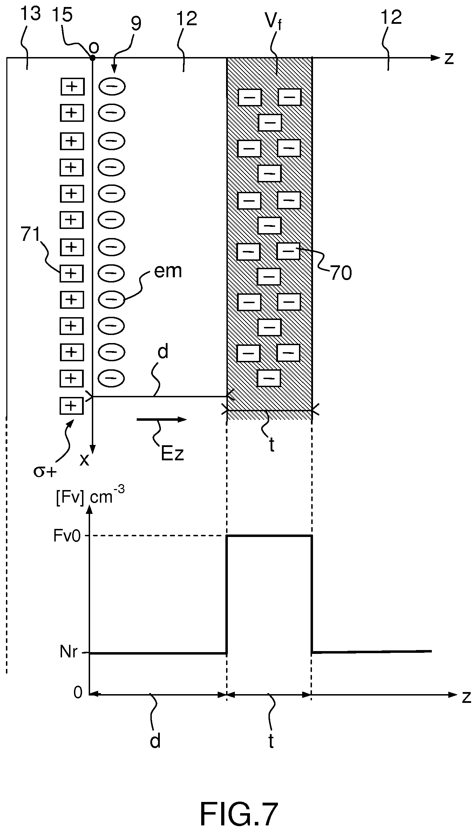

La figure 7 décrit plus précisément la répartition et la nature des charges dans l'empilement selon l'invention. Le caractère fixe d'une charge est symbolisé par un rectangle entourant cette charge, tandis que le caractère mobile est symbolisé par un ovale.

Comme décrit plus haut, du fait d'un effet piézo-électrique, une densité surfacique $\sigma+$ de charges positives fixes 71 est présente au voisinage de l'hétérojonction, et des charges négatives mobiles em également situées à proximité de l'hétérojonction constituent le gaz bidimensionnel d'électrons à l'origine du fonctionnement du transistor HEMT. La densité surfacique d'électrons em dans le canal est typiquement d'environ 0.5 à 3 $10^{13}$ $cm^{-2}$.

La zone Vf de l'empilement selon l'invention comprend des charges négatives fixes 70.

Ces charges négatives fixes présentent une densité volumique [Fv] classiquement exprimée en $cm^{-3}$.

Après de nombreuses expérimentations et simulations, les inventeurs ont déterminé des plages de paramètres [Fv], et t de la zone Vf pour lesquels le transistor HEMT, réalisé sur l'empilement comme décrit précédemment, présente un bon fonctionnement, particulièrement un bon « pincement » et une faible dispersion de courant (« lag »). L'obtention d'un bon fonctionnement signifie également que les inconvénients liés aux empilements selon l'état de la technique tels que : diminution de la puissance émise, baisse de rendement, réduction de la linéarité ... sont réduits, voir supprimés.

L'idée générale de l'invention est d'introduire dans la couche tampon 12 la charge électrique négative fixe qui est juste nécessaire à l'obtention de bonnes caractéristiques de transfert aux tensions et aux fréquences de fonctionnement souhaitées. Le contrôle de la quantité de charges et de leur position par rapport au gaz 2D d'électron permet :

- d'obtenir un bon confinement des électrons dans le canal sans créer de phénomènes de piégeage indésirables qui entraînent une dégradation de la linéarité (effets dispersifs) et une diminution de la puissance disponible et du rendement,
- sans dégrader la conductivité thermique du « buffer » par exemple en GaN.

Les paramètres [Fv] et t sont reliés à des grandeurs physiques intervenant dans le fonctionnement du transistor HEMT réalisé à partir de l'empilement 10 selon l'invention.
Une première grandeur physique est le champ électrique E créé du fait de l'existence de la zone Vf.
Le champ électrique E selon l'axe z Ez créé entre l'hétérojonction 15 et la zone Vf vérifie la relation:

$$\text{div}Ez = q.[Fs] \, / \, \varepsilon_0.\varepsilon_r$$

avec : q charge de l'électron, $\varepsilon_0$ permittivité diélectrique du vide, $\varepsilon_r$ permittivité relative de la couche tampon, [Fs] densité surfacique de charges négatives « vues » par les charges mobiles em du canal (exprimée en $cm^{-2}$). On a :

$$[Fs] \approx [Fv].t$$

La présence du champ électrique Ez crée par la zone Vf de charges négatives a pour effet de confiner les électrons dans le canal, ce qui permet d'obtenir un « bon pincement ».
Ainsi pour que ce champ Ez soit suffisant pour confiner les électrons, les inventeurs ont montré que les grandeurs [Fv] et t et doivent être comprises dans les plages suivantes :

$$[Fv] \geq 10^{17} \, cm^{-3}$$

$$t \leq 200 \, nm$$

$$10^{12} \, cm^{-2} \leq [Fv] \, .t \leq 3. \, 10^{13} \, cm^{-2}$$

Le paramètre [Fv].t représente la dose de charges négatives, qui doit être optimale et disposée à proximité de l'interface 15.
Un avantage de l'invention est que la localisation et le dosage des charges négatives introduites permet d'introduire la quantité de charge qui est juste nécessaire au confinement des électrons (cette quantité dépendant par ailleurs de la tension de fonctionnement et de la longueur de grille comme décrit plus loin), tout en limitant la perte de puissance par rapport à une approche selon laquelle l'intégralité du buffer est « dopée » en impuretés de type accepteur.
Les plages revendiquées doivent également être respectées pour assurer une faible dispersion du courant, comme décrit plus loin.
Le profil de densité volumique de charges négatives fixes selon l'axe z peut être de forme quelconque, la forme n'intervenant pas au premier ordre dans les effets physiques en cause.
La figure 7 illustre un profil en forme de créneau de valeur constante Fv0.
La valeur minimale Nr correspond à la densité de charges négatives fixes résiduelles dans la couche tampon 12, pour une couche tampon dite « compensée » selon l'état de la technique. Dans ce cas la couche tampon dans son ensemble présente un excès de concentration en impuretés de type accepteur par rapport à la concentration en impuretés de type donneur supérieur à $10^{15} \, cm^{-3}$, correspondant à la densité résiduelle Nr.

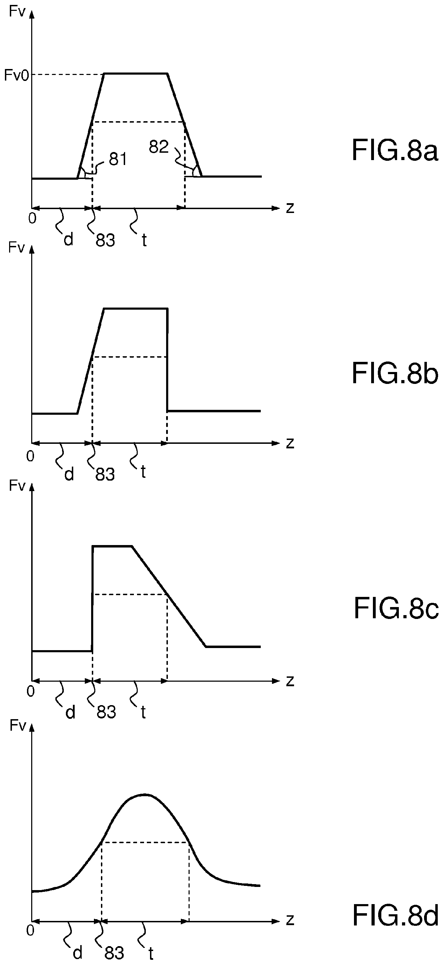

La figure 8 (8a à 8d) illustre différentes formes de profil de densité volumique [Fv] selon l'invention.
La figure 8a illustre un profil trapézoïdal présentant une première pente croissante 81 puis une valeur constante Fv0 puis une deuxième pente décroissante 82. La figure 8b illustre un profil présentant une première pente croissante, une valeur constante et une deuxième pente abrupte. La figure 8c illustre un profil présentant une première pente abrupte, une valeur constante et une deuxième pente décroissante. La figure 8d illustre un profil en cloche.

L'empilement 10 selon l'invention peut présenter tout autre type de profil présentant une densité de charges volumique localisée dans une épaisseur t vérifiant les conditions précédentes. Pour un profil quelconque, l'épaisseur t peut être évaluée à mi-hauteur entre la valeur maximale et la valeur résiduelle. La distance d à l'hétérojonction 15 peut être évaluée par rapport au point 83 correspondant au point à mi-hauteur du côté de l'hétérojonction 15.

Préférentiellement les charges négatives fixes 70 localisées dans la couche tampon 12 sont obtenues à partir d'impuretés de type accepteur A introduites dans la couche tampon 12. Ces atomes de type accepteurs sont préférentiellement du carbone ou du fer, ou du magnésium ou du béryllium ou tout type d'impuretés connues pour être un centre accepteur dans le GaN ou l'AlGaN.

Ces impuretés sont par exemple introduites en faisant varier les conditions d'épitaxie de la couche tampon 12 ou en introduisant volontairement ces impuretés lors de la croissance de la couche tampon 12.

Ces impuretés A ne réalisent pas une fonction de dopage au sens classique du terme, puisqu'ils constituent des centres profonds.

Ces impuretés de type accepteur sont en interaction de type électrostatique avec les charges positives fixes 71 formant le plan de charge $\sigma+$ situé au voisinage de l'hétérojonction 15, et sont plus ou moins ionisées selon leur distance d à cette hétérojonction 15 et à leur position dans la bande interdite du matériau constituant la couche tampon.

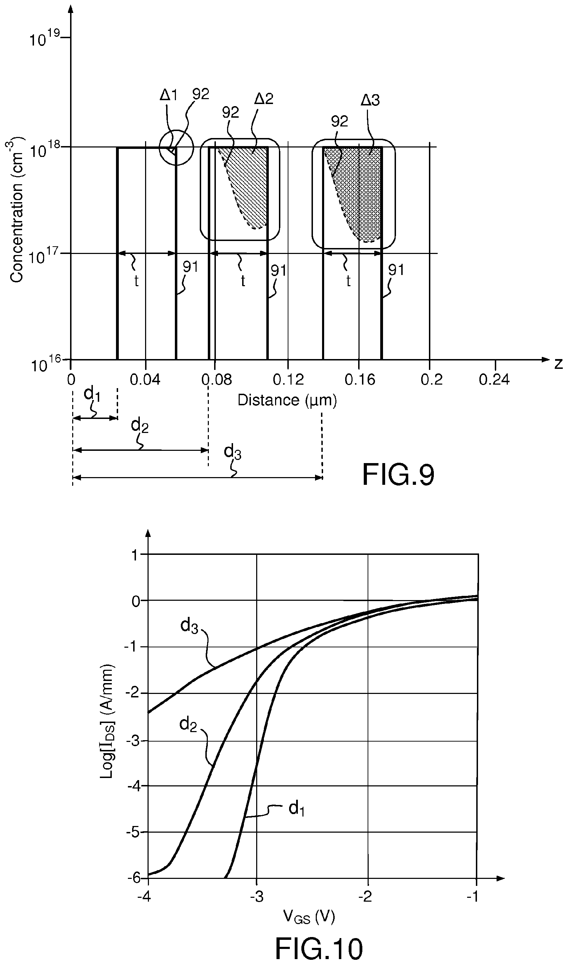

Une deuxième grandeur physique intervenant pour le fonctionnement du transistor HEMT réalisé à partir de l'empilement selon l'invention est le paramètre $\Delta$ défini comme suit, et illustré sur la figure 9. $\Delta = \int_0^t ([A] - [A^-]).\mathrm{dz}$

(en $cm^{-2}$)

Avec :

[A] densité volumique d'impuretés A (également dénommés défauts) de type accepteur introduites dans la couche tampon 12. On a donc [A] = [Fv].

[A$^-$] la densité volumique d'impuretés dite « chargées » ou « ionisées » par interaction électrostatique (ionisation du défaut qui entraîne une capture d'un électron par le centre profond), chaque impureté « chargée » correspondant à une charge négative fixe « figée » par interaction électrostatique.

Nous allons à présent expliciter la signification physique de la grandeur $\Delta$, et pour cela préciser le sens du terme « figé » et « non figé ».

Un centre accepteur à deux états possibles : soit il est occupé par un électron et est alors chargé négativement, soit il est vide et est dans ce cas neutre. Le taux d'occupation de ces centres (c.a.d. le nombre de centres occupés par un électron et donc la quantité de charge négative liée à ces centres) dépend des conditions d'utilisations (fréquence, température et tension). Ceci a pour conséquence que le niveau de puissance dépend des conditions d'utilisations.

Ces impuretés étant des centres profonds, aux températures de fonctionnement du transistor (25°C à 250°C typiquement), le temps nécessaire pour que ces centres atteignent leur état d'équilibre est plus long que les temps caractéristiques de fonctionnement du transistor (fréquences de fonctionnement typique de l'ordre de 1GHz à 100GHz qui correspondent à des tensions qui changent périodiquement en 1 ns à 10ps environ).

Ces centres ne répondent donc pas immédiatement au signal appliqué. Il s'ensuit que la charge négative portée par ces impuretés et par conséquent le niveau de courant et de puissance dépend du temps et des différentes tensions appliquées. On observe donc une évolution du signal au cours du temps indépendante du signal appliqué à l'instant t qui dégrade la linéarité. Cependant si ces impuretés sont suffisamment proches de l'interface, alors par interaction électrostatique, une partie de ces impuretés (celles les plus proches de cette interface) seront chargées quelle que soit la tension appliquée au transistor. Leur état ne dépendra alors plus des conditions d'utilisation du transistor. On aura alors moins d'effet dispersif et un fonctionnement plus linéaire du transistor. La grandeur $\Delta$ quantifie ces effets dispersifs, elle représente la quantité de charges négatives fixes dont l'état dépend des conditions d'utilisations.

Ainsi dans ce contexte, le terme « figé » signifie que l'état du centre accepteur ne dépend pas des conditions d'utilisations, et le terme « non figé » signifie que l'état du centre accepteur dépend des conditions d'utilisations.

La grandeur $\Delta$ se définit par la quantité d'impuretés, ici négatives, introduites dans la couche tampon pour améliorer le pincement (et donc le gain du transistor) **moins** la quantité d'impuretés dont l'état est « figé » par la présence de la charge piézoélectrique. $\Delta$ représente donc le résiduel d'impuretés non figées dont l'état de charge évoluera au gré des conditions d'utilisations (température, fréquence, tension). En d'autres termes, $\Delta$ représente le nombre d'impuretés par unité de surface n'ayant pas capturé d'électrons (c'est-à-dire « non figé ») dont l'état va dépendre des conditions d'utilisation. Ces centres vont donc potentiellement pouvoir capturer un électron, la quantité de centres accepteurs capturant un électron dépendant des conditions d'utilisation.

Le profil 91 (traits pleins) sur la figure 9 correspond au profil initial [A], le profil 92 (traits en pointillé) correspond au profil [A⁻].

La différence entre les deux profils correspond à la surface hachurée $\Delta$ sur la figure 9.

Les simulations pour calculer le profil [A⁻] ont été réalisées pour trois valeurs de distance d à l'hétérojonction 15, d1 = 25 nm, d2 = 75 nm, d3=140 nm, et avec les hypothèses suivantes :

Impuretés de type accepteur introduites dans la couche tampon avec une densité volumique [A]=$10^{18}$cm$^{-3}$ et formant une zone Vf présentant un profil en forme de créneau et une épaisseur t = 40 nm et dont le niveau d'énergie $E_T$ dans la bande interdite du matériau constituant la couche tampon se trouve à $E_T = E_V+0.9eV$.

De plus la longueur de grille Lg du transistor réalisé sur l'empilement est dans cet exemple de 150 nm, qui correspond à une grille dite « courte ». Les différentes applications visées couvrent des tailles de grille typiquement inférieures à 4$\mu$m. Les inventeurs ont mis en évidence une dépendance des performances du transistor en fonction de la distance d à l'hétérojonction de la zone Vf, cette dépendance étant fonction de la taille de la grille Lg.

Lors de la mise sous tension du transistor HEMT (dans cet exemple $V_{GS}$ = - 3V et $V_{DS}$ = 40V), les impuretés non initialement chargées ($\Delta$) vont se charger. Lors d'un retour à $V_{GS}$ = -3V et $V_{DS}$ = 40V ces impuretés étant des centres profonds restent chargées aux fréquences de fonctionnement du transistor. Ainsi, les impuretés dont la charge négative n'est pas figée par effet électrostatique ont un état qui se modifie par application d'une tension. Cette modification provoque une variation du courant et donc de la puissance disponible (diminution ou augmentation selon que l'on accroisse ou que l'on réduise la tension de polarisation du transistor).

On constate sur la figure 9 que les charges non figées sont de plus en plus nombreuses au fur et à mesure que la zone Vf est éloignée de l'hétérojonction située à l'origine O. (donc dispersion plus importante du courant).

On remarque également que, pour une distance d donnée, ces charges apparaissent du côté opposé à celui de l'hétérojonction 15. En effet, du côté de l'hétérojonction, les impuretés sont plus proches des charges positives fixes, donc l'interaction électrostatique avec la densité surfacique $\sigma+$ est plus importante et permet de figer l'état des charges.

Dans l'exemple donné sur la figure 9 (tension maximale appliquée sur le drain du transistor de 40V), la simulation physique indique :

$$\Delta 1 \approx 0.1.\ 10^{12}\ cm^{-2}$$

$$\Delta 2 \approx 1.9.\ 10^{12}\ cm^{-2}$$

$$\Delta 3 \approx 2.7.\ 10^{12}\ cm^{-2}$$

La figure 10 illustre la caractéristique $Log[I_{DS}] = f(V_{GS})$ pour un transistor HEMT réalisé avec l'empilement selon l'invention décrit précédemment, pour un point de fonctionnement (appelé « quiescent point» en langage anglo-saxon-noté QP ici) $I_{DS\_QP}$ = 100mA/mm ($V_{GS\_MAX}$ = -6V dans cet exemple) et $V_{DS\_QP}$ = 20V ($V_{DS\_MAX}$ = 2 x $V_{DS\_QP}$ = 40V), pour une zone Vf réalisée selon les trois distances précédentes. On constate que la caractéristique est très bonne pour d1 = 25 nm, un peu moins bonne pour d2 = 75 nm et mauvaise pour d3=140 nm.

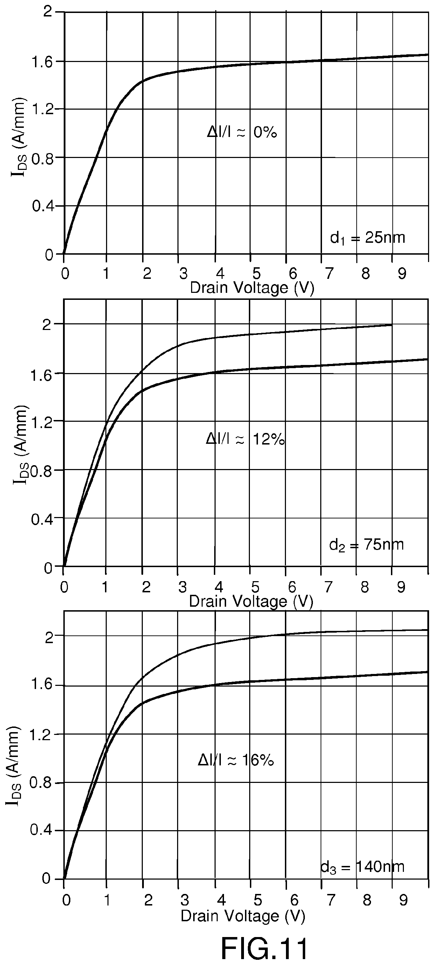

La figure 11 illustre la dispersion en courant telle qu'explicitée plus haut pour les trois cas précités. On constate que cette dispersion augmente lorsque d augmente.

Ainsi pour une grille « courte » de longueur Lg typiquement inférieure à 200 nm, un bon fonctionnement du transistor est obtenu pour une zone Vf située à une distance d< 100 nm de l'hétérojonction 15.

Pour une distance d trop importante, les charges piégées non figées deviennent trop nombreuses, et un phénomène analogue à celui constaté par les inventeurs pour un dopage P homogène sur l'ensemble de la couche tampon est observé (mauvais pincement et dispersion en courant). Une distance d trop importante réduit également le champ électrique Ez de confinement des électrons.

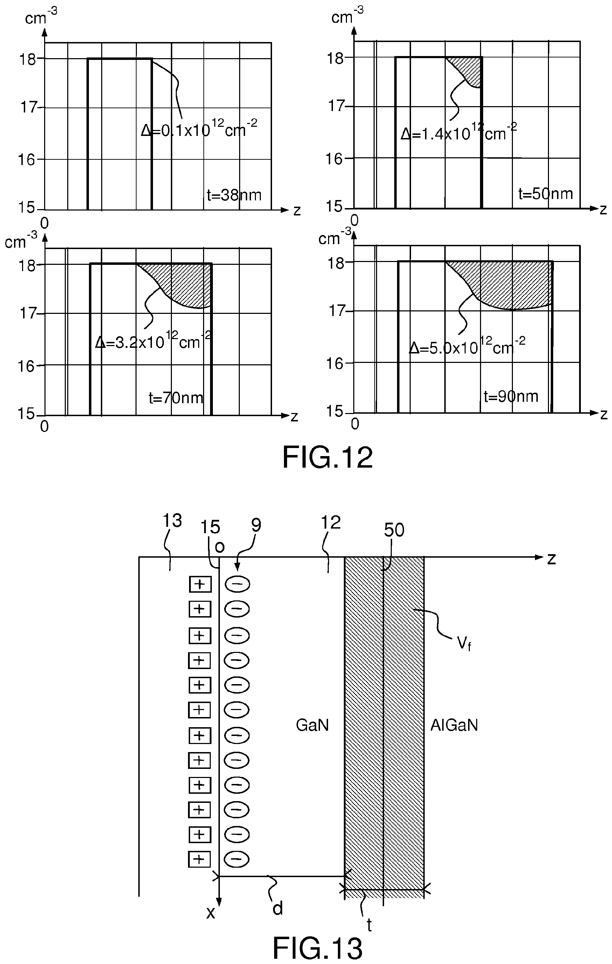

La figure 12 illustre l'évolution du paramètre $\Delta$ en fonction de l'épaisseur t de la zone Vf présentant un profil en forme de créneau avec des impuretés de type accepteur dont le niveau d'énergie $E_T$ dans la bande interdite du matériau constituant la couche tampon se trouve à $E_T = E_V+0.9eV$ et avec une densité volumique [A]=$10^{18}$cm$^{-3}$.

Plus la valeur de t augmente (de 38 nm à 90 nm) plus la valeur de $\Delta$ augmente. La valeur d'épaisseur t maximum pour laquelle le transistor conserve un bon fonctionnement est également fonction de la densité d'impuretés introduites [A] et de la distance à l'hétérojonction d.

Il ressort des considérations précédentes relatives aux figures 9 à 12 que, pour un fonctionnement le plus linéaire possible du transistor réalisé sur l'empilement selon l'invention, et afin de réduire la perte de puissance et de rendement du transistor, on cherche à minimiser le paramètre $\Delta$.

Une valeur de $\Delta$ proche de 0 correspond à la situation dans laquelle la densité surfacique de charges négatives fixes $\int_0^t [A^-].dz$ est sensiblement égale à la densité surfacique d'impuretés de type accepteur $\int_0^t [A].dz$ introduites dans la zone Vf de la couche tampon 12.

Une condition d'optimum correspond à une valeur de $\Delta$ telle que :

$\Delta \leq 10^{12}$ cm$^{-2}$

Pour cela une concentration volumique [Fv] suffisamment élevée d'impuretés doit être placée à une distance d suffisamment proche de l'interface 15 (de manière à rendre l'épaisseur t de cette couche la plus fine possible pour un produit [Fv].t donné) pour que toutes les impuretés introduites présentent des charges dans un état figé (tous les « dopants » sont ionisés et le restent pour toutes les conditions d'utilisation). Dans cette situation, la dispersion temporelle sur la transconductance gm et le courant est réduite, ce qui représente un avantage pour les applications dans lesquelles les aspects de linéarité du signal sont importants.

Cette condition est par exemple vérifiée pour un empilement selon l'invention pour transistor HEMT avec :

$$[Fv] \geq 10^{18} \text{ cm}^{-3}$$

$$t \leq 40 \text{ nm.}$$

$$[Fv].t \leq 4.10^{12} \text{ cm}^{-2}$$

et d $\leq$40 nm.

En première approximation cette condition préférentielle est indépendante de la longueur de la grille Lg du transistor réalisé à partir de l'empilement.

Selon un autre aspect, l'invention concerne un transistor à effet de champ à haute mobilité électronique réalisé à partir d'un empilement selon l'invention.

De plus, suite à de nombreuses expérimentations et simulations, les inventeurs ont dégagé des conditions préférentielles de dimensionnement du transistor HEMT selon l'invention, c'est-à-dire réalisé à partir de l'empilement selon l'invention, en fonction de l'application souhaitée.

Lors du fonctionnement du transistor, une partie des impuretés introduites dans le buffer pour améliorer le « pincement » se charge négativement. Ces charges fixes correspondent aux impuretés qui passent d'un état neutre (pas d'électrons capturés) à un état chargé négativement (capture d'un électron par le centre profond). La quantité d'impureté capturant un électron dépend des conditions d'utilisations (température, fréquence, tension) et des caractéristiques du profil de ces impuretés (d, t et [Fv]).

Les inventeurs ont mis en évidence qu'un bon fonctionnement du transistor est obtenu préférentiellement lorsque la distance d est inférieure ou égale à la longueur de la grille Lg du transistor selon l'invention : d $\leq$ Lg.

Par simulation on peut établir une relation semi-empirique reliant la densité surfacique de charge fixes (en cm$^2$) à réaliser dans l'empilement, en fonction de la longueur de grille Lg et de la tension maximale appliquée sur le drain $V_{DSMax}$. Cette relation a été validée par simulation pour une densité d'électrons dans le canal allant jusqu'à $3\times10^{13}$/cm$^2$, pour une longueur de grille Lg comprise entre 50nm et 4 $\mu$m, et une tension $V_{DSMax}$ allant jusqu'à quelques kV (pour les grilles les plus longues) soit :

$$[Fv] . t = [Fs_{opt}] = (1\pm0.3) \times 10^{13} \times V_{DSMAX} / Lg \quad \text{(relation n°1)}$$

avec [Fs$_{opt}$] en cm$^{-2}$, Lg en nm et $V_{DSMAX}$ en V

Par exemple, pour une tension de fonctionnement maximale $V_{DSMAX}$ de 40V et une longueur de grille de 150nm, il faut réaliser :

$$[Fs_{opt}] = (1\pm0.3) \times 10^{13} \times 40V / 150nm,$$

soit environ $(2.7\pm0.8) \times 10^{12}$ charges fixes/cm$^2$,

Dans les trois exemples qui vont suivre, on se place dans le cas ou $\Delta \approx 0$ soit $\Delta <10^{12}$/cm$^2$ (cas le plus favorable du point de vue dispersion du signal). On prend également t = 40nm, et [Fv] = $10^{18}$cm$^{-3}$ respectivement soit [A] = [Fv]. t=$4\times10^{12}$cm$^2$.

La relation 1 peut s'écrire sous deux formes équivalentes selon le paramètre, longueur de grille ou tension maximale de fonctionnement, que l'on cherche à optimiser :
Si c'est la tension on a :

$$V_{MAX} = Lg \times ([Fv]^*t)/((1\pm0.3)\times10^{13}) \quad \text{(relation n°2)}$$

Si c'est la longueur de grille alors :

$$Lg = V_{MAX} \times ((1\pm0.3)\times10^{13})/([Fv]^*t) \quad \text{(relation n°3)}$$

-Application télécom spatiale à 30GHz :

Dans ces applications la longueur de grille est comprise entre 50nm et 150nm. On utilise la relation n°2, et on trouve :

- pour une longueur de grille Lg=50nm : $V_{MAX} \approx$ 15V à 28V
- pour une longueur de grille Lg=150nm : $V_{MAX} \approx$ 45V à 85V

-Application en commutation du type « envelope tracking » :

Dans ce cas on veut avoir la grille la plus courte possible (temps de commutation le plus court) pouvant fonctionner à 60V. On utilise la relation n°3 et on obtient :

$$Lg = V_{MAX} \times (1\pm0.3)\times10^{13}/([Fv]^*t) = 60 \times (1\pm0.3)\times10^{13}/(4\times10^{12})$$
$$\approx 100nm \text{ à } 200nm.$$

-Application en commutation de puissance pour l'automobile :

Dans ce cas on veut tenir des tensions de 650V à 1300V. La longueur de grille doit donc être de l'ordre de :

- Pour 650V :

$$Lg = V_{MAX} \times (1\pm0.3)\times10^{13}/([Fv]^*d) = 650 \times (1\pm0.3)\times10^{13}/(4\times10^{12})$$
$$\approx 1\mu m \text{ à } 2\mu m.$$

- Pour 1300V :

$$Lg=V_{MAX} \times (1\pm0.3)\times10^{13}/([Fv]^*d) = 1300 \times (1\pm0.3)\times10^{13}/(4\times10^{12})$$
$$\approx 2\mu m \text{ à } 4\mu m.$$

L'empilement selon l'invention est compatible de l'utilisation d'une couche tampon 12 composite, comprenant une première couche tampon à base de matériau GaN et une deuxième couche tampon à base de matériau AlGaN. On note 50 l'interface entre le GaN et l'AlGaN (voir figure 5). La présence d'une zone Vf selon l'invention permet de diminuer le pourcentage d'aluminium dans le matériau AlGaN, par exemple en dessous de 5%, avec pour avantage de réduire l'augmentation de la résistance thermique de cette deuxième couche tampon.
Selon une variante préférée illustrée figure 13 la zone Vf est comprise dans la première couche tampon.
Selon une autre variante, la zone Vf est comprise dans la deuxième couche tampon.
Selon une autre variante, la zone Vf comprend l'interface 50.

**Revendications**

1. Empilement (10) selon un axe z pour transistor à effet de champ à haute mobilité électronique comprenant :

   - une couche tampon (12) comprenant un premier matériau semi-conducteur comprenant un composé binaire ou ternaire ou quaternaire de nitrure et présentant une première bande interdite,
   - une couche barrière (13) comprenant un deuxième matériau semi-conducteur comprenant un composé binaire ou ternaire ou quaternaire de nitrure et présentant une deuxième bande interdite,
   - la deuxième bande interdite étant supérieure à la première bande interdite,
   - une hétérojonction (15) entre ladite couche tampon (12) et ladite couche barrière (13) et,
   - un gaz bidimensionnel d'électrons (9) localisé dans un plan xy perpendiculaire à l'axe z et au voisinage de l'hétérojonction (15),

   dans lequel:

   - ladite couche tampon (12) comprend une zone (Vf) comprenant des charges négatives fixes (70) de densité volumique ([Fv]) supérieure ou égale à $10^{17}$ cm$^{-3}$, ladite zone (Vf) présentant une épaisseur (t) inférieure ou égale à 200 nm, **caractérisé en ce que**:

   le produit de la densité volumique de charges négatives fixes ([Fv]) par l'épaisseur (t) de la zone (Vf) étant compris entre $10^{12}$ cm$^{-2}$ et $3.10^{13}$ cm$^{-2}$, lesdites charges fixes étant obtenues à partir d'impuretés de type accepteur (A) introduites dans ladite couche tampon.

2. Empilement selon la revendication 1 dans lequel les impuretés de type accepteur sont du Carbone ou du Fer ou du Magnésium.

3. Empilement selon l'une des revendications précédentes dans lequel la densité surfacique de charges négatives fixes $\int_0^t [A^-].\,dz$ est sensiblement égale à la densité surfacique d'impuretés de type accepteur $\int_0^t [A].\,dz$ introduites dans la zone Vf de la couche tampon (12).

4. Empilement selon l'une des revendications précédentes dans lequel la densité volumique de charges négatives fixes ([Fv]) est supérieure ou égale à $10^{18}$ cm$^{-3}$, l'épaisseur (t) de la zone (Vf) est inférieure ou égale à 40 nm, le produit de la densité volumiques de charges négatives fixes ([Fv]) par l'épaisseur (t) de la zone (Vf) est inférieur ou égal à $4.10^{12}$ cm$^{-2}$, et la distance (d) de la zone (Vf) à l'hétérojonction (15) est inférieure ou égale à 40 nm.

5. Empilement selon l'une des revendications précédentes dans lequel le premier matériau semi conducteur comprend du GaN.

6. Empilement selon l'une des revendications précédentes dans lequel le deuxième matériau semi conducteur comprend de l'AlN, de l'AlGaN, de l'InAlN, de l'InGaAlN ou du BAlGaN.

7. Empilement selon l'une des revendications précédentes dans lequel la densité volumique de charges négatives fixes ([Fv]) présente un profil selon l'axe z en forme de créneau.

8. Empilement selon l'une des revendications 1 à 6 dans lequel la densité volumique de charges négatives fixes ([Fv]) présente un profil selon l'axe z trapézoïdal présentant une première pente croissante puis une valeur constante puis une deuxième pente décroissante.

9. Empilement selon l'une des revendications 1 à 6 dans lequel la densité volumique de charges négatives fixes ([Fv]) présente un profil selon l'axe z en forme de cloche.

10. Empilement selon l'une des revendications précédentes dans lequel la couche tampon (12) est composite, comprenant une première couche tampon à base de matériau GaN et une deuxième couche tampon à base de matériau AlGaN, ladite zone (Vf) étant comprise dans la première couche tampon.

11. Transistor à effet de champ à haute mobilité électronique réalisé à partir d'un empilement selon l'une des revendications précédentes.

**12.** Transistor selon la revendication 11 présentant une longueur de grille (Lg) dans lequel la distance (d) à l'hétérojonction de la zone (Vf) est inférieure ou égale à la longueur de grille (Lg).

**13.** Transistor selon l'une des revendications 11 ou 12 dans lequel le produit de la densité volumique de charges négatives fixes ([Fv]) par l'épaisseur (t) de la zone (Vf) vérifie la relation suivante :

$$[Fv]. \, t = (1 \pm 0.3) \times 10^{13} \times V_{DSMAX} / Lg$$

dans laquelle :

Lg est la longueur de grille du transistor, en nm
$V_{DSMAX}$ est la tension maximale appliquée entre la source et le drain du transistor, en Volt,
[Fv]. t est exprimé en $cm^{-2}$.

**Patentansprüche**

**1.** Stapel (10) entlang einer Achse z für Feldeffekttransistor mit hoher elektronischer Mobilität, Folgendes beinhaltend:

- eine Pufferschicht (12), welche ein erstes Halbleitermaterial beinhaltet, welches eine binäre oder ternäre oder quaternäre Nitridverbindung enthält und ein erstes verbotenes Band aufweist,
- eine Barriereschicht (13), welche ein zweites Halbleitermaterial beinhaltet, welches eine binäre oder ternäre oder quaternäre Nitridverbindung enthält und ein zweites verbotenes Band aufweist,
- wobei das zweite verbotene Band höher ist als das erste verbotene Band,
- einen Heteroübergang (15) zwischen der Pufferschicht (12) und der Barriereschicht (13), und
- ein zweidimensionales Elektronengas (9), welches in einer Ebene xy lokalisiert ist, welche in der Nähe des Heteroübergangs (15) rechtwinklig zur Achse z verläuft, wobei:
- die Pufferschicht (12) einen Bereich (Vf) beinhaltet, welcher feste negative Ladungen (70) mit einer Volumendichte ([Fv]) größer oder gleich $10^{17}$ $cm^{-3}$ beinhaltet, wobei der Bereich (Vf) eine Dicke (t) aufweist, welche kleiner oder gleich 200 nm beträgt, **dadurch gekennzeichnet, dass**:

das Produkt der Volumendichte negativer fester Ladungen ([Fv]) mal der Dicke (t) des Bereichs (Vf) zwischen $10^{12}$ $cm^{-2}$ und $3.10^{13}$ $cm^{-2}$ beträgt, wobei die festen Ladungen anhand von Verunreinigungen vom Typ Akzeptor (A) erzielt werden, welche in die Pufferschicht eingebracht werden.

**2.** Stapel nach Anspruch 1, bei welchem die Verunreinigungen vom Typ Akzeptor Kohlenstoff oder Eisen oder Magnesium sind.

**3.** Stapel nach einem der vorhergehenden Ansprüche, bei welchem die Oberflächendichte fester negativer Ladungen $\int_0^t [A^-]. \, dz$ im Wesentlichen gleich einer Oberflächendichte von Verunreinigungen vom Typ Akzeptor $\int_0^t [A^-]. \, dz$ ist, welche in den Bereich Vf der Pufferschicht (12) eingebracht werden.

**4.** Stapel nach einem der vorhergehenden Ansprüche, bei welchem die Volumendichte fester negativer Ladungen ([Fv]) größer oder gleich $10^{18}$ $cm^{-3}$ beträgt, die Dicke (t) des Bereichs (Vf) kleiner oder gleich 40 nm beträgt, das Produkt der Volumendichte negativer fester Ladungen ([Fv]) mal der Dicke (t) des Bereichs (Vf) kleiner oder gleich $4.10^{12}$ $cm^{-2}$ beträgt, und der Abstand (d) zwischen dem Bereich (Vf) und dem Heteroübergang (15) kleiner oder gleich 40 nm beträgt.

**5.** Stapel nach einem der vorhergehenden Ansprüche, bei welchem das erste Halbleitermaterial GaN beinhaltet.

**6.** Stapel nach einem der vorhergehenden Ansprüche, bei welchem das zweite Halbleitermaterial AlN, AlGaN, InAlN, InGaAlN oder BAlGaN beinhaltet.

7. Stapel nach einem der vorhergehenden Ansprüche, bei welchem die Volumendichte fester negativer Ladungen ([Fv]) ein Profil entlang der Achse z in Form einer Zinne aufweist.

8. Stapel nach einem der Ansprüche 1 bis 6, bei welchem die Volumendichte fester negativer Ladungen ([Fv]) ein trapezförmiges Profil entlang der Achse z aufweist, welches eine erste ansteigende Schräge, dann einen konstanten Wert und anschließend eine zweite, absteigende Schräge aufweist.

9. Stapel nach einem der Ansprüche 1 bis 6, bei welchem die Volumendichte fester negativer Ladungen ([Fv]) ein Profil entlang der Achse z in Form einer Glocke aufweist.

10. Stapel nach einem der vorhergehenden Ansprüche, bei welchem die Pufferschicht (12) eine Verbundschicht ist, welche eine erste Pufferschicht auf der Grundlage von GaN-Material und eine zweite Pufferschicht auf der Grundlage von AlGaN-Material beinhaltet, wobei der Bereich (Vf) in der ersten Pufferschicht beinhaltet ist.

11. Feldeffekttransistor mit hoher elektronischer Mobilität, welcher anhand eines Stapels nach einem der vorhergehenden Ansprüche gebildet wird.

12. Transistor nach Anspruch 11, welcher eine Gitterlänge (Lg) aufweist, in welcher der Abstand (d) zum Heteroübergang des Bereichs (Vf) kleiner als die oder gleich der Gitterlänge (Lg) ist.

13. Transistor nach einem der Ansprüche 11 oder 12, bei welchem das Produkt der Volumendichte negativer fester Ladungen ([Fv]) mal der Dicke (t) des Bereichs (Vf) folgendes Verhältnis bewahrheitet:

$$[Fv].t = (1 \pm 0.3) \text{ x } 10^{13} \text{ x } V_{DSMAX} / Lg$$

wobei:

Lg die Länge des Transistorgitters in nm ist,
$V_{DSMAX}$ die maximale angelegte Spannung zwischen der Quelle und dem Drain des Transistors in Volt ist,
$[Fv].t$ in $cm^{-2}$ ausgedrückt wird.

**Claims**

1. A stack (10) along a z-axis for a high-electron-mobility field-effect transistor, comprising:

   - a buffer layer (12) comprising a first semiconductor material comprising a binary or ternary or quaternary nitride compound and having a first bandgap,
   - a barrier layer (13) comprising a second semiconductor material comprising a binary or ternary or quaternary nitride compound and having a second bandgap,
   - the second bandgap being wider than the first bandgap,
   - a heterojunction (15) between said buffer layer (12) and said barrier layer (13) and,
   - a two-dimensional electron gas (9) located in an xy plane perpendicular to the z-axis and in the vicinity of the heterojunction (15),

   wherein:

   - said buffer layer (12) comprises a zone (Vf) comprising fixed negative charges (70) of density per unit volume ([Fv]) higher than or equal to $10^{17}$ $cm^{-3}$, said zone (Vf) having a thickness (t) smaller than or equal to 200 nm, **characterized in that**:

      the product of multiplication of the density per unit volume of fixed negative charges ([Fv]) by the thickness (t) of the zone (Vf) being comprised between $10^{12}$ $cm^{-2}$ and $3.10^{13}$ $cm^{-2}$, said fixed charges being obtained from acceptor-type impurities (A) introduced into said buffer layer.

2. The stack according to claim 1, wherein the acceptor-type impurities are carbon or iron or magnesium.

3. The stack according to any of the preceding claims, wherein the density per unit area of fixed negative charges $\int_0^t [A^-] . dz$ is substantially equal to the density per unit area of acceptor-type impurities $\int_0^t [A] . dz$ introduced into the zone Vf of the buffer layer (12).

4. The stack according to any of the preceding claims, wherein the density per unit volume of fixed negative charges ([Fv]) is higher than or equal to $10^{18}$ cm$^{-3}$, the thickness (t) of the zone (Vf) is smaller than or equal to 40 nm, the product of multiplication of the density per unit volume of fixed negative charges ([Fv]) by the thickness (t) of the zone (Vf) is lower than or equal to $4 \times 10^{12}$ cm$^{-2}$, and the distance (d) from the zone (Vf) to the heterojunction (15) is smaller than or equal to 40 nm.

5. The stack according to any of the preceding claims, wherein the first semiconductor material comprises GaN.

6. The stack according to any of the preceding claims, wherein the second semiconductor material comprises AlN, AlGaN, InAlN, InGaAlN or BAlGaN.

7. The stack according to any of the preceding claims, wherein the density per unit volume of fixed negative charges ([Fv]) has a top-hat-shaped profile along the z-axis.

8. The stack according to any of claims 1 to 6, wherein the density per unit volume of fixed negative charges ([Fv]) has a trapezoidal profile along the z-axis having a first increasing slope then a constant value then a second decreasing slope.

9. The stack according to any of claims 1 to 6, wherein the density per unit volume of fixed negative charges ([Fv]) has a bell-shaped profile along the z-axis.

10. The stack according to any of the preceding claims, wherein the buffer layer (12) is a composite comprising a first buffer layer based on GaN material and a second buffer layer based on AlGaN material, said zone (Vf) being contained in the first buffer layer.

11. A high-electron-mobility field-effect transistor produced from a stack according to any of the preceding claims.

12. The transistor as claimed in claim 11 having a gate length (Lg), wherein the distance (d) to the heterojunction from the zone (Vf) is smaller than or equal to the gate length (Lg).

13. The transistor according to any of claims 11 and 12, wherein the product of multiplication of the density per unit volume of fixed negative charges ([Fv]) by the thickness (t) of the zone (Vf) respects the following relationship:

$$[Fv].t = (1 \pm 0.3) \text{ x } 10^{13} \text{ x } V_{DSMAX} / Lg$$

in which:

Lg is the gate length of the transistor, in nm
$V_{DSMAX}$ is the maximum voltage applied to between the source and drain of the transistor, in volts,
[Fv].t is expressed in cm$^{-2}$.

FIG.1

FIG.2

FIG.3

$$\frac{\Delta I}{I} \approx 60\%$$

FIG.4

FIG.5

FIG.6

FIG.7

FIG.8a

FIG.8b

FIG.8c

FIG.8d

FIG.9

FIG.10

FIG.11

FIG.12

FIG.13

**EP 3 127 160 B1**

## RÉFÉRENCES CITÉES DANS LA DESCRIPTION

**Documents brevets cités dans la description**

- US 20130328106 A